(19) Europäisches Patentamt
European Patent Office
Office européen des brevets

(11) EP 2 176 948 B1

(12) EUROPÄISCHE PATENTSCHRIFT

(45) Veröffentlichungstag und Bekanntmachung des Hinweises auf die Patenterteilung:
**28.09.2011 Patentblatt 2011/39**

(51) Int Cl.:
*H03C 3/40* (2006.01)   *H03C 5/00* (2006.01)
*H03D 7/16* (2006.01)   *H04L 27/36* (2006.01)

(21) Anmeldenummer: **08773379.6**

(22) Anmeldetag: **10.06.2008**

(86) Internationale Anmeldenummer:
**PCT/EP2008/004630**

(87) Internationale Veröffentlichungsnummer:
**WO 2009/018871 (12.02.2009 Gazette 2009/07)**

(54) **VERFAHREN UND ANORDNUNG ZUM ERZEUGEN EINES FREQUENZMODULIERTEN SIGNALS**

METHOD AND ARRANGEMENT FOR PRODUCTION OF A FREQUENCY-MODULATED SIGNAL

PROCÉDÉ ET ENSEMBLE DE PRODUCTION D'UN SIGNAL À FRÉQUENCE MODULÉE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **06.08.2007 DE 102007036982**
**21.11.2007 DE 102007055529**

(43) Veröffentlichungstag der Anmeldung:
**21.04.2010 Patentblatt 2010/16**

(73) Patentinhaber: **Rohde & Schwarz GmbH & Co. KG**
**81671 München (DE)**

(72) Erfinder:
• **RICHT, Norbert**
**85570 Markt Schwaben (DE)**
• **LORENZ, Petr**
**83661 Lenggries (DE)**

(74) Vertreter: **Körfer, Thomas**
**Mitscherlich & Partner**
**Patent- und Rechtsanwälte**
**Sonnenstrasse 33**
**80331 München (DE)**

(56) Entgegenhaltungen:
WO-A-01/67592          GB-A- 2 236 225
US-A- 5 224 119        US-A1- 2003 129 955
US-A1- 2006 178 119

## Beschreibung

Die Erfindung betrifft ein Verfahren laut Oberbegriff des Hauptanspruches sowie eine Anordnung zum Ausführen dieses Verfahrens.

In der Hochfrequenzmesstechnik werden oftmals frequenzmodulierte Ausgangssignale gebraucht, die einerseits einen relativ großen Frequenzhub (Bandbreite) besitzen und die außerdem eine Trägerfrequenz aufweisen, die in einem großen Frequenzbereich beispielsweise zwischen 1 GHz und 40 GHz einstellbar ist. Dies ist mit bekannten frequenzmodulierbaren Signalgeneratoren nicht erreichbar, je nach Eigenschaften des Generators sind damit höchstens Frequenzhübe von 10 - 20 MHz erreichbar. Mit sogenannten vektoriellen IQ-modulierbaren Mikrowellengeneratoren ist unter Verwendung von sogenannten AWG-Funktionsgeneratoren (arbitrary waveform generator) beispielsweise nach US 5,224,119 je nach verwendeten Digital-/Analog-Wandlern ein Frequenzhub von bis zu 100 MHz möglich. Ein größerer Frequenzhub ist jedoch auch mit diesen bekannten Anordnungen nicht erreichbar.

Aus der WO 01/67592 A2 ist nun eine Anordnung zum Erzeugen eines breitbandig frequenzmodulierten Ausgangssignals bekannt, die in der Lage ist mit Hilfe einer IQ-Demodulatoreinheit und einer IQ-Modulatoreinheit ein frequenzmoduliertes Eingangssignal in ein breitbandig frequenzmoduliertes Ausgangssignals zu wandeln. Dabei kann anstelle eines rein frequenzmodulierten Eingangssignals bspw. auch ein Eingangssignal mit kombinierten Modulationstechniken vorgesehen sein. Derartige Signale sind unter anderem aus der US 2006/0178119 A1 bekannt, in der bspw. ein Eingangssignal gezeigt wird, das sowohl eine Frequenz- als auch Amplitudenmodulation aufweist. Somit ist bereits das Eingangssignal sowohl frequenz- als auch amplitudenmoduliert.

Aufgabe der Erfindung ist nun, ein Verfahren und eine Anordnung aufzuzeigen, mit dem bzw. der ein frequenzmoduliertes Hochfrequenz-Ausgangssignal erzeugbar ist, dessen Trägerfrequenz in einem großen Frequenzbereich beliebig einstellbar ist und das trotzdem mit einem beliebig großen Frequenzhub erzeugt werden kann und dabei eine Alternative zur Amplitudenmodulation des Eingangssignals zu zeigen.

Diese Aufgabe wird ausgehend von einem Verfahren laut Oberbegriff des Anspruches 1 durch dessen kennzeichnende Merkmale gelöst. Vorteilhafte Weiterbildungen ergeben sich aus den Unteransprüchen. Eine Anordnung zum Ausführen des erfindungsgemäßen Verfahrens ist in Anspruch 3 angegeben.

Beim erfindungsgemäßen Verfahren wird ein frequenzmoduliertes Ausgangssignal beispielsweise am Ausgang eines üblichen IQ-modulierbaren Mikrowellen-Signalgenerators dadurch erzeugt, dass zunächst auf einer beliebigen festen Trägerfrequenz in bekannter Weise ein frequenzmoduliertes Signal erzeugt wird, das dann vektoriell in entsprechende IQ-Signale umgesetzt wird, die schließlich im IQ-modulierbaren Signalgenerator mit der gewünschten Trägerfrequenz aus dem breiten Frequenzbereich zum frequenzmodulierten Ausgangssignal umgesetzt wird. Zur zusätzlichen Amplitudenmodulation des Ausgangssignals werden die vektoriell umgesetzten IQ-Signale noch amplitudenmoduliert, sodass beispielsweise sehr breitbandige frequenzmodulierte Signale mit bestimmter Hüllkurve erzeugt werden können.

Vorzugsweise werden dabei die zunächst noch mit den Signalkomponenten der zur Erzeugung des frequenzmodulierten Signals benutzten Trägerfrequenz behafteten IQ-Signale einer Tiefpassfilterung unterworfen und so die IQ-Signale erzeugt.

Eine besonders einfache Anordnung zur Ausführung eines solchen Verfahrens ergibt sich aus dem Anspruch 4, denn zur Erzeugung des frequenzmodulierten Signals auf der beliebigen festen Trägerfrequenz kann jeder bekannte FM-Modulator benutzt werden. Die vektorielle Signalumsetzung in die IQ-Signale, bei der es sich im Prinzip um eine IQ-Demodulation handelt, kann mit einem üblichen IQ-Demodulator durchgeführt werden. Die Erzeugung des frequenzmodulierten Ausgangssignals aus diesen IQ-Signalen kann dann anschließend in einem üblichen IQ modulierbaren Mikrowellensignalgenerator erfolgen. Zur zusätzlichen Amplitudenmodulation des Ausgangssignals ist zwischen dem IQ-Demodulator und dem IQ-Modulator in den I- und Q-Zweigen jeweils noch ein Amplitudenmodulator angeordnet.

Mit dem erfindungsgemäßen Verfahren kann so auf einer Trägerfrequenz beispielsweise zwischen 1 GHz und 44 GHz ein frequenzmoduliertes Signal von beliebig großem Frequenzhub (Bandbreite) erzeugt werden, abhängig von der Bandbreite des IQ-Modulators, des IQ-Demodulators und des frequenzmodulierten Signals auf der beliebigen festen Trägerfrequenz. Das erfindungsgemäße Verfahren arbeitet dabei rein analog und vermeidet so Bandbreiten-begrenzende Digital-/Analog-Wandler und digitale Signalverarbeitung. In einfacheren Fällen kann das erfindungsgemäße Verfahren jedoch auch in Digitaltechnik ausgeführt werden.

Die Erfindung wird im Folgenden anhand einer schematischen Zeichnung an einem Ausführungsbeispiel näher erläutert. In der Zeichnung zeigt:

Fig. 1    ein Beispiel einer Anordnung zum Erzeugen eines frequenzmodulierten Hochfrequenz- Ausgangssignals.

Fig. 2    2 Möglichkeiten für eine zusätzliche AM- Modulation

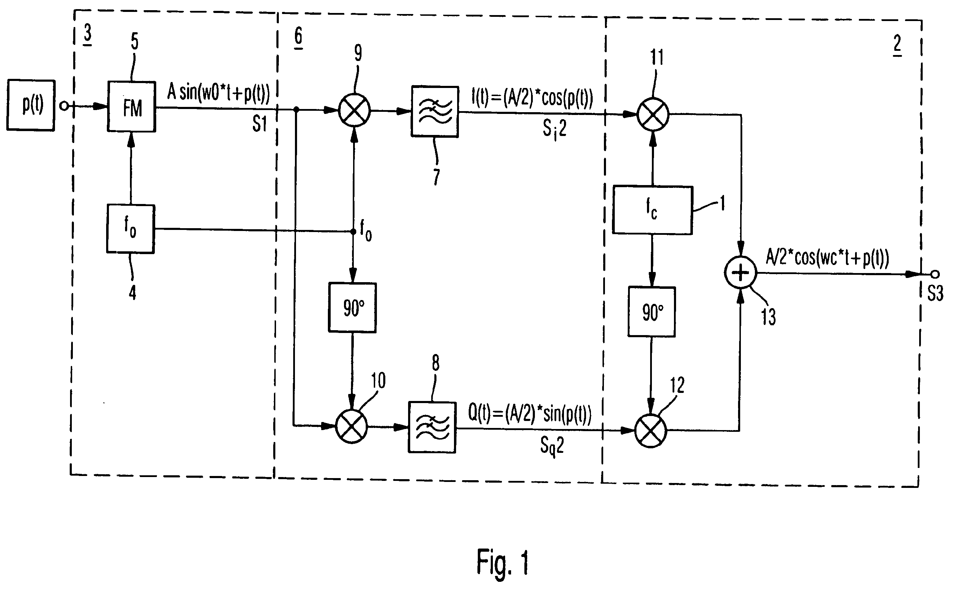

Die Fig. 1 zeigt eine Anordnung zum Erzeugen eines frequenzmodulierten Hochfrequenz-Ausgangssignals S3, dessen Trägerfrequenz $f_c$ in einem großen Frequenzbereich mit beliebig großem Frequenzhub mittels eines Frequenzgenerators 1 eines üblichen IQ-Signalgenerators 2 einstellbar ist. Dazu wird zunächst in einem üblichen FM-Modulator 3 das aufzumodulierende Modulationssignal in einem Modulator 5 mit der beliebigen jedoch festen Trägerfrequenz $f_0$ eines HF-Generators 4 zum frequenzmodulierten Signal S1 umgesetzt. In einem nach Art eines üblichen IQ-Demodulators arbeitenden vektoriellen Umsetzer 6 wird mit der gleichen festen Trägerfrequenz $f_0$ das Signal S1 in die IQ-Signalbestandteile umgesetzt. Dazu werden in bekannter Weise in Frequenzumsetzern 9 und 10 einerseits mit der In-Phasenkomponente und andererseits mit der um 90° gedrehten Quadratur-Phasenkomponente der Trägerfrequenz $f_0$ wie bei einem IQ-Demodulator die IQ Signale erzeugt.

In anschließenden Tiefpassfiltern 7 und 8 werden die IQ-Signale $S_i2$ und $S_q2$ erzeugt. Die so ins Basisband umgesetzten IQ-Signale $S_i2$ und $S_q2$ werden schließlich dem darauffolgenden IQ-Modulator 2 zugeführt und dort mit der ausgewählten Trägerfrequenz $f_c$ zum gewünschten frequenzmodulierten Ausgangssignal S3 vereinigt. Mit der In-Phasenkomponente bzw. der 90° Phasenverschobenen Quadratur-Phasenkomponente der Trägerfrequenz $f_c$ werden mittels der Frequenzumsetzer 11 und 12 die IQ-Signale auf die Trägerfrequenz $f_c$ umgesetzt und im Summierglied 13 zum frequenzmodulierten Ausgangssignal S3 zusammengefasst.

Der Frequenzmodulator 3 ist vorzugsweise so ausgebildet, dass er bei der festen Frequenz $f_0$ einen möglichst großen, linearen Frequenzhub besitzt, also sehr breitbandig ist. Hierfür ist beispielsweise ein VCO (Voltage-controlled oscillator) geeignet.

Mit der beschriebenen Anordnung wird so aus einem frequenzmodulierten Signal (FM-Signal) S1 mit einer festen Trägerfrequenz $f_0$ nach folgenden Formeln ein frequenzmoduliertes Ausgangssignal S3 mit einer Trägerfrequenz $f_c$ erzeugt und zwar mit großem Frequenzhub, abhängig vom IQ-Modulator, IQ-Demodulator und vom Frequenzhub des frequenzmodulierten Signals auf der beliebig festen Trägerfrequenz.

Ein frequenzmoduliertes Signal (FM-Signal) $s_1(t)$ mit Trägerfrequenz $f_0$ ist durch die Gleichung

$$s_1(t) = A\sin\left(w_0 t + p(t)\right) = A\sin\left(\varphi(t)\right)$$

gegeben, mit der Amplitude $A$, der Kreisfrequenz $w_0 = 2\pi f_0$ und dem Signal $p(t)$, das gegeben ist durch

$$p(t) = \int_0^t f(r)\,dr = F(t) - F(0).$$

mit der Funktion $F(t) = \int f(t)\,dt$.

Die momentane Kreisfrequenz $w(t)$ ergibt sich aus den Gleichungen (1) und (2) zu

$$w(t) = \frac{d\varphi(t)}{dt} = w_0 + \frac{dp(t)}{dt} = w_0 + f(t).$$

In den Gleichungen (2) und (3) stellt das Signal $f(t)$ das Modulationssignal dar.

Wird das FM-Signal (1) mit jeweils $\sin(w_0 t)$ und $\cos(w_0 t)$ multipliziert, so ergeben sich folgende Signale

$$s_1(t)\sin(w_0 t) = \frac{A}{2}\cos\left(p(t)\right) - \frac{A}{2}\cos\left(2w_0 t + p(t)\right), \qquad (4a)$$

$$s_1(t)\cos(w_0 t) = \frac{A}{2}\sin\left(p(t)\right) + \frac{A}{2}\sin\left(2w_0 t + p(t)\right). \qquad (4b)$$

Durch Tiefpassfiltern dieser Signale ergeben sich die zeitabhängigen $I(t)$ und $Q(t)$ Signale

$$S_i 2(t) = I(t) = \frac{A}{2}\cos(p(t)) , \qquad (5a)$$

$$S_q 2(t) = Q(t) = \frac{A}{2}\sin(p(t)) . \qquad (5b)$$

Das IQ-modulierte Signal $s_{1Q}(t)$ mit der Trägerfrequenz $f_c$ ist durch

$$s_{IQ}(t) = \Re\left(\left(I(t) + jQ(t)\right)e^{jw_c t}\right) = I(t)\cos(w_c t) - Q(t)\sin(w_c t) \qquad (6)$$

gegeben. Durch Einsetzen der Ausdrücke aus (5) in diese Gleichung ergibt sich

$$S_3(t) = s_{IQ}(t) = \frac{A}{2}\cos(w_c t + p(t)) . \qquad (7)$$

Die Gleichung (7) beschreibt ein frequenzmoduliertes Signal mit Trägerfrequenz $f_c$.

Das erfindungsgemäße Verfahren ist insbesondere für I/Qmodulierbare Mikrowellen-Signalgeneratoren geeignet, die in einem breiten Frequenzband beispielsweise zwischen 1 GHz und 44 GHz abstimmbar sind. Nach dem erfindungsgemäßen Verfahren kann ein solcher Generator sehr einfach zur Erzeugung eines frequenzmodulierten Ausgangssignals benutzt werden, indem nur noch ein entsprechender Frequenzmodulator mit fester Trägerfrequenz und ein anschließender üblicher IQ-Demodulator vorgeschaltet werden.

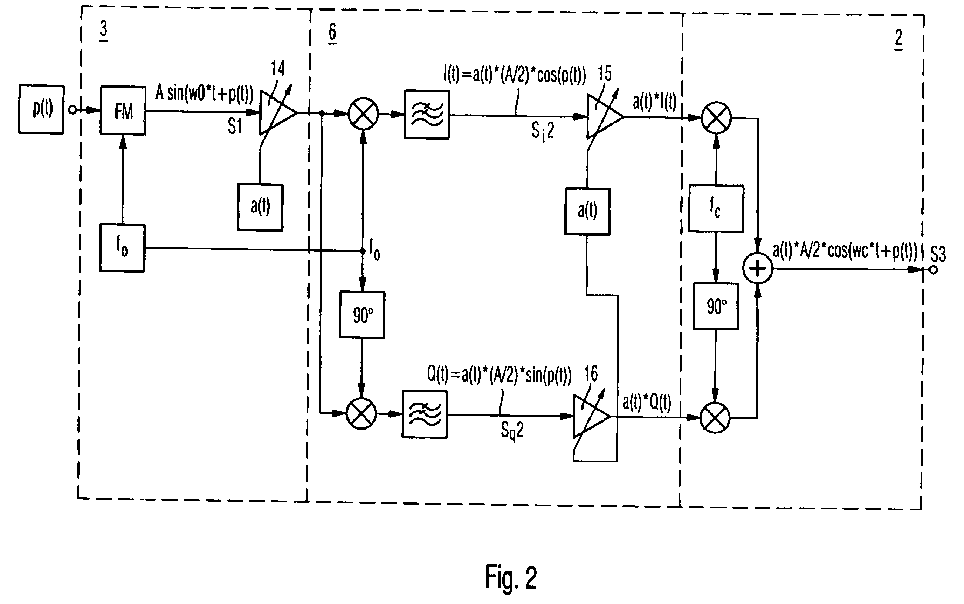

Fig. 2 zeigt zwei Möglichkeiten für die zusätzliche Amplitudenmodulation des breitbandig frequenzmodulierten Ausgangssignals S3. Die Grundschaltung für die Erzeugung des frequenzmodulierten Ausgangssignals entspricht Fig. 1. Eine erste nicht erfindungsgemäße Möglichkeit zur zusätzlichen Amplitudenmodulation, wie dies beispielsweise für frequenzmodulierte Signale mit bestimmter Hüllkurve erforderlich ist, besteht darin, mittels eines zusätzlichen Amplitudenmodulators 14 vor dem Umsetzer 6 die Amplitude des auf einer festen Trägerfrequenz erzeugten frequenzmodulierten Signals S1 mit dem beispielsweise der Hüllkurve entsprechenden Amplitudenmodulationssignal a(t) zu modulieren. Die Amplituden der anschließend im Umsetzer 6 erzeugten I- und Q-Signale $S_i 2$ und $S_q 2$ werden so mit dem Signal a (t) multipliziert. Bei diesem Verfahren wird die Amplitudenmodulation im Frequenzbereich des frequenzmodulierten Signals S1 durchgeführt.

Mit den beiden Amplitudenmodulatoren 15 und 16 ist nun die erfindungsgemäße Möglichkeit der zusätzlichen Amplitudenmodulation dargestellt, deren Vorteil darin besteht, dass die Amplitudenmodulation der I/Q-Signale im Basisband erfolgt. Die beiden Amplitudenmodulatoren 15 und 16 sind jeweils im Umsetzer 6 unmittelbar nach den Tiefpassfiltern 7,8 im I bzw. Q-Zweig angeordnet und werden wieder mit dem Amplitudenmodulationssignal a (t) angesteuert.

In den beiden Beispielen sind als Amplitudenmodulatoren jeweils steuerbare Verstärker dargestellt, es sind jedoch auch andere Amplitudenmodulatoren wie steuerbare Dämpfungsglieder oder der gleichen einsetzbar.

Die Erfindung ist nicht auf das beschriebene Ausführungsbeispiel beschränkt. Alle technischen und/oder gezeichneten Merkmale sind beliebig im Rahmen der durch die Ansprüche definierten Erfindung miteinander kombinierbar.

**Patentansprüche**

1. Verfahren zum Erzeugen eines breitbandig frequenzmodulierten Ausgangssignals (S3), dessen Trägerfrequenz ($f_c$) in einem großen Frequenzbereich einstellbar ist, wobei ein frequenzmoduliertes Signal (S1) auf einer beliebigen festen Trägerfrequenz ($f_o$) erzeugt wird, dieses frequenzmodulierte Signal (S1) vektoriell in IQ-Signale ($S_i 2$, $S_q 2$) umgesetzt wird und die so erzeugten IQ-Signale dann mit der gewünschten Trägerfrequenz ($f_c$) durch IQ-Modulation zum frequenzmodulierten Ausgangssignal (S3) zusammengefasst werden,
   **dadurch gekennzeichnet,**
   **dass** zur zusätzlichen Amplitudenmodulation des Ausgangssignals (S3) die vektoriell umgesetzten IQ-Signale ($S_i 2$, $S_q 2$) amplitudenmoduliert werden.

**2.** Verfahren nach Anspruch 1,
**dadurch gekennzeichnet,**
**dass** die erzeugten IQ-Signale vor der IQ-Modulation tiefpassgefiltert werden.

**3.** Anordnung zum Erzeugen eines frequenzmodulierten Ausgangssignals (S3), dessen Trägerfrequenz ($f_c$) in einem großen Frequenzbereich einstellbar ist, insbesondere nach dem Verfahren gemäß Anspruch 1 oder 2,aufweisend einen Frequenzmodulator (3) zum Erzeugen eines auf einer beliebigen jedoch festen Trägerfrequenz ($f_o$) mit einer Signalfrequenz frequenzmodulierten
Signals (S1),
einen anschließenden nach Art eines IQ-Demodulators arbeitenden vektoriellen Umsetzer (6), durch den das frequenzmodulierte Signal (S1) vektoriell in ein durch IQ-Signale ($S_i2$, $S_q2$) gebildetes Eingangssignal eines IQ-modulierbaren Signalgenerators umgesetzt wird, mit einem darauf folgenden IQ-Modulator (2), durch den die IQ-Signale mit der gewünschten Trägerfrequenz ($f_c$) zum frequenzmodulierten Ausgangssignal (S3) zusammengefasst werden,
**dadurch gekennzeichnet,**
**dass** zwischen dem vektoriellen Umsetzer (6) und dem IQ-Modulator (2) in den I- und Q-Zweigen jeweils ein Amplitudenmodulator (15, 16) angeordnet ist.

**4.** Anordnung nach Anspruch 3,
**dadurch gekennzeichnet,**
**dass** am Ausgang des vektoriellen Umsetzers (6) Tiefpassfilter (7,8) zum Ausfiltern der Trägerfrequenz-Signalkomponenten ($f_o$) angeordnet sind.

**Claims**

**1.** Method of generating a broadband frequency-modulated output signal (S3), the carrier frequency ($f_c$) of which is adjustable within a wide frequency range, wherein a frequency-modulated signal (S1) is generated on an arbitrary fixed carrier frequency ($f_o$), this frequency-modulated signal (S1) is converted vectorially into IQ signals ($S_i2$, $S_q2$), and the thus generated IQ signals are then combined with the desired carrier frequency ($f_c$) by IQ modulation into the frequency-modulated output signal (S3),
**characterized in that**
for additional amplitude modulation of the output signal (S3), the vectorially converted IQ signals ($S_i2$, $S_q2$) are amplitude-modulated.

**2.** Method according to Claim 1,
**characterized in that**
the generated IQ signals are low-pass-filtered before IQ modulation.

**3.** Arrangement for generating a frequency-modulated output signal (S3), the carrier frequency ($f_c$) of which is adjustable within a wide frequency range, in particular according to the method according to Claim 1 or 2, having
a frequency modulator (3) for generating a signal (S1) which is frequency-modulated with a signal frequency on an arbitrary but fixed carrier frequency ($f_o$),
a subsequent vectorial converter (6), which works like an IQ demodulator, and converts the frequency-modulated signal (S1) vectorially into a input signal, which is formed by IQ signals ($S_i2$, $S_q2$), of an IQ-modulatable signal generator, with a subsequent IQ modulator (2), which combines the IQ signals with the desired carrier frequency ($f_c$) into the frequency-modulated output signal (S3),
**characterized in that**
between the vectorial converter (6) and the IQ modulator (2), in each of the I and Q branches an amplitude modulator (15, 16) is arranged.

**4.** Arrangement according to Claim 3,
**characterized in that**
at the output of the vectorial converter (6), low pass filters (7, 8) are arranged, to filter out the carrier frequency signal components ($f_o$).

**Revendications**

1. Procédé pour générer un signal de sortie modulé en fréquence à large bande (S3), dont la fréquence porteuse ($f_c$) peut être réglée dans un grand domaine de fréquences, dans lequel un signal modulé en fréquence (S1) est généré sur une fréquence porteuse fixe quelconque ($f_o$), ce signal modulé en fréquence (S1) est converti vectoriellement en signaux IQ ($S_i2$, $S_q2$) et les signaux IQ ainsi générés sont réunis à la fréquence porteuse souhaitée ($f_c$) par modulation IQ en un signal de sortie modulé en fréquence (S3),
**caractérisé en ce que**
en vue de la modulation d'amplitude supplémentaire du signal de sortie (S3), les signaux IQ convertis vectoriellement ($S_i2$, $S_q2$) sont modulés en amplitude.

2. Procédé selon la revendication 1, **caractérisé en ce que**
les signaux IQ générés sont soumis à un filtrage passe-bas avant la modulation IQ.

3. Dispositif pour générer un signal de sortie modulé en fréquence (S3), dont la fréquence porteuse ($f_c$) peut être réglée dans un grand domaine de fréquences, en particulier conformément au procédé selon la revendication 1 ou 2, comportant un modulateur de fréquences (3) pour générer un signal modulé en fréquence (S1) avec une fréquence de signal sur une fréquence porteuse quelconque mais fixe ($f_o$),
un convertisseur vectoriel (6) ensuite fonctionnant comme un démodulateur IQ, grâce auquel le signal modulé en fréquence (S1) est converti vectoriellement en un signal d'entrée formé par les signaux IQ ($S_i2$, $S_q2$) d'un générateur de signaux modulable IQ, comportant un modulateur IQ (2) placé après, grâce auxquels les signaux IQ sont réunis à la fréquence porteuse souhaitée ($f_c$) pour un signal de sortie modulé en fréquence (S3),
**caractérisé en ce que**
un modulateur d'amplitude (15, 16) est disposé respectivement entre le convertisseur vectoriel (6) et le modulateur IQ (2) dans les branches I et Q.

4. Dispositif selon la revendication 3, **caractérisé en ce que**
des filtres passe-bas (7, 8) sont disposés à la sortie du convertisseur vectoriel (6) pour filtrer les composantes de signal de fréquence porteuse ($f_o$).

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5224119 A
- WO 0167592 A2
- US 20060178119 A1